# EUROPEAN PATENT APPLICATION

(11) **EP 4 446 762 A1**
(43) Date of publication of application: **16.10.2024**
(21) Application number: 22904229.6
(22) Date of filing: 06.12.2022
(51) Int. Cl.: G01R 31/392, G01R 31/379, G01R 31/3828, G01R 31/385, H01M 10/42, H01M 10/44, H01M 10/48, H02J 7/00

(54) **LEAD-ACID BATTERY SYSTEM AND LEAD-ACID BATTERY DETERIORATION ESTIMATION METHOD**

(30) Priority: 10.12.2021 JP 2021200685; 10.12.2021 JP 2021200686
(71) Applicant: FURUKAWA ELECTRIC CO., LTD., Tokyo 100-8322 (JP); The Furukawa Battery Co., Ltd., Yokohama-shi, Kanagawa-ken 240-0006 (JP)
(72) Inventor: TANIMURA Yudai, Tokyo 100-8322 (JP); NAKAMURA Hideto, Tokyo 100-8322 (JP); KUTSUMA Ayaka, Tokyo 100-8322 (JP); SATO Toshiyuki, Yokohama-shi, Kanagawa 240-0006 (JP); YOSHIDA Hideaki, Nikko-shi, Tochigi 321-2336 (JP)
(74) Representative: Grünecker Patent- und Rechtsanwälte PartG mbB
(86) International application number: PCT/JP2022/044984
(87) International publication number: WO 2023/106301

(57) **Abstract**

Provided are a lead-acid battery system and a lead-acid battery life estimation method, which can contribute to improvement of reliability by more accurately estimating a degradation degree of a lead-acid battery regardless of a degradation cause. A transition determination unit (131) that determines switching of charging/discharging process of a lead-acid battery (B), a calculation unit (132) that calculates a CT value on the basis of a discharge current value during a discharge period of a storage battery, and a degradation determination unit (134) that determines a degradation degree of the lead-acid battery using the CT value calculated by the calculation unit (132) are included.

## Description

### Technical Field

Embodiments of the present invention relate to a lead-acid battery system and a lead-acid battery life estimation method.

### Background Art

In recent years, there have been an increasing number of power generation facilities using renewable energy such as sunlight and wind power. In such power generation facilities, the amount of power generation cannot be controlled, and thus storage batteries are used to level the power load. That is, when the amount of power generation is larger than the amount of consumption, the difference is charged into storage batteries, and when the amount of power generation is smaller than the amount of consumption, the difference is discharged from the storage batteries.

Examples of such storage batteries include lead-acid batteries and lithium-ion secondary batteries. These storage batteries for power storage are installed in houses, offices, and sites of factories, electric power companies, and the like. The storage batteries are assumed to be used in units of several years to 10 years from the start of operation.

When long-term use is assumed as described above, it is necessary to periodically perform maintenance and management (maintenance) after the start of operation. This is because in the case of various storage batteries as described above, it is known that degradation progresses with use and available battery capacity decreases. On the other hand, these storage batteries are not replaced immediately even if their capacity is lost after single discharge as in the primary battery, but are repeatedly used. Thus, it is required to appropriately ascertain the state of installed storage batteries.

When the storage battery is a lead-acid battery using lead, examples of the cause of the decrease in capacity include a decrease in adhesion between a positive electrode current collector and a positive active material. However, there is a possibility of the characteristics of the lead-acid battery not changing unless it comes close to the end of the lifespan of the lead-acid battery, and it may be difficult to determine the degradation degree of the lead-acid battery that causes the change. In particular, in the case of a bipolar lead-acid battery, degradation may rapidly progress, and it is required to estimate the degradation degree with higher accuracy.

Examples of a method for estimating the degradation degree of a storage battery include a method disclosed in PTL 1 below. In the invention described in PTL 1, in order to determine the lifespan of the storage battery, the charged electricity amount is measured and the temperature of the storage battery is measured. Then, the temperature of the storage battery obtained in advance is converted into the charged electricity amount at a constant temperature on the basis of the relationship with the integrated value of the charged electricity amount until reaching the end of its lifespan, and the lifespan of the storage battery is calculated.

### Citation List

### Patent Literature

PTL 1: JP H2-288075 A

### Summary of Invention

### Technical Problem

In the invention described in PTL 1, as described above, the lifespan of the storage battery is determined using the relationship with the temperature. However, for example, the degradation of the lead-acid battery is not only a decrease in adhesion between the positive electrode current collector and the positive active material as described above.

That is, examples of the cause of degradation of the bipolar lead-acid battery include peeling of the active material, softening of the active material, sulfation, and the like. In the case of these causes, an influence of a C rate and a depth of discharge (DOD) cannot be ignored, and the degree of influence on the degradation of the bipolar lead-acid battery changes for each discharging process. Therefore, a method for estimating the degradation degree of a lead-acid battery with higher accuracy is required.

An object of the present invention is to provide a lead-acid battery system and a lead-acid battery life estimation method, which can contribute to improvement of reliability by more accurately estimating a degradation degree of a lead-acid battery regardless of a degradation cause.

### Solution to Problem

A lead-acid battery system according to an aspect of the present invention includes a transition determination unit configured to determine switching of charging/discharging process of a lead-acid battery; a calculation unit configured to calculate a CT value based on a discharge current value during a discharge period of the lead-acid battery; and a degradation determination unit configured to determine a degradation degree of the lead-acid battery using the CT value calculated by the calculation unit.

A lead-acid battery life estimation method according to an aspect of the present invention includes: determining whether or not a lead-acid battery is switched from a charging process to a discharging process; measuring a current in the discharging process when it is determined that the lead-acid battery is switched to the discharging process; integrating measured discharge current values; determining whether the lead-acid battery is switched from the discharging process to the charging process; and executing a calculation process of a CT value using the integrated discharge current value when it is determined that the lead-acid battery is switched from the discharging process to the charging process.

A lead-acid battery life estimation method according to an aspect of the present invention includes: determining whether or not a lead-acid battery is switched from a charging process to a discharging process; starting measurement of a preset set time; measuring a current in the discharging process after the measurement of the set time is started; integrating measured discharge current values; determining whether the set time has elapsed; executing a calculation process of a CT value using the integrated discharge current value when it is determined that the set time has elapsed; and calculating a sum of the CT values calculated for each set time.

### Advantageous Effects of Invention

As described above, a lead-acid battery system according to an aspect of the present invention includes: a transition determination unit configured to determine switching of charging/discharging process of a lead-acid battery; a calculation unit configured to calculate a CT value based on a discharge current value during a discharge period of the lead-acid battery; and a degradation determination unit configured to determine a degradation degree of the lead-acid battery using the CT value calculated by the calculation unit. Therefore, by more accurately estimating the degradation degree of the lead-acid battery regardless of the cause of degradation, it is possible to contribute to improvement of reliability.

### Brief Description of Drawings

FIG. 1 is a block diagram illustrating an overall configuration of a lead-acid battery system according to an embodiment of the present invention;
FIG. 2 is a block diagram illustrating an internal configuration of a BMU according to the embodiment of the present invention;
FIG. 3 is a block diagram illustrating a detailed internal configuration of a state determination unit according to a first embodiment of the present invention;
FIG. 4 is an explanatory view illustrating a time course of charging/discharging process of the lead-acid battery in the first embodiment of the present invention;
FIG. 5 is a flowchart illustrating a flow of determining a degradation degree of a lead-acid battery using the lead-acid battery system according to the first embodiment of the present invention;
FIG. 6 is a flowchart illustrating a flow of determining a degradation degree of a lead-acid battery using the lead-acid battery system according to the first embodiment of the present invention;
FIG. 7 is a flowchart illustrating a flow of determining a degradation degree of a lead-acid battery using the lead-acid battery system according to the first embodiment of the present invention;
FIG. 8 is a flowchart illustrating another flow of determining the degradation degree of the lead-acid battery using the lead-acid battery system according to the first embodiment of the present invention;
FIG. 9 is a flowchart illustrating another flow of determining the degradation degree of the lead-acid battery using the lead-acid battery system according to the first embodiment of the present invention;
FIG. 10 is a flowchart illustrating another flow of determining the degradation degree of a lead-acid battery using the lead-acid battery system according to the first embodiment of the present invention;
FIG. 11 is a block diagram illustrating a detailed internal configuration of a state determination unit according to a second embodiment of the present invention;
FIG. 12 is an explanatory view illustrating a time course of charging/discharging process of a lead-acid battery in the second embodiment of the present invention;
FIG. 13 is a flowchart illustrating a flow of determining a degradation degree of a lead-acid battery using the lead-acid battery system according to the second embodiment of the present invention;
FIG. 14 is a flowchart illustrating a flow of determining a degradation degree of a lead-acid battery using the lead-acid battery system according to the second embodiment of the present invention;
FIG. 15 is a flowchart illustrating a flow of determining a degradation degree of a lead-acid battery using the lead-acid battery system according to the second embodiment of the present invention;
FIG. 16 is a flowchart illustrating another flow of determining the degradation degree of a lead-acid battery using the lead-acid battery system according to the second embodiment of the present invention;
FIG. 17 is a flowchart illustrating another flow of determining the degradation degree of a lead-acid battery using the lead-acid battery system according to the second embodiment of the present invention; and
FIG. 18 is a flowchart illustrating another flow of determining the degradation degree of a lead-acid battery using the lead-acid battery system according to the second embodiment of the present invention.

### Description of Embodiments

Hereinafter, embodiments of the present invention will be described in detail with reference to the drawings. Note that the embodiments described below illustrate examples of the present invention. In addition, various changes or improvements can be added to the present embodiments, and a mode to which such changes or improvements are added can also be included in the present invention. These embodiments and modifications thereof are included in the scope and gist of the invention, and are included in the scope of the invention described in the claims and its equivalents.

### (First Embodiment)

### [Configuration of Lead-Acid Battery System]

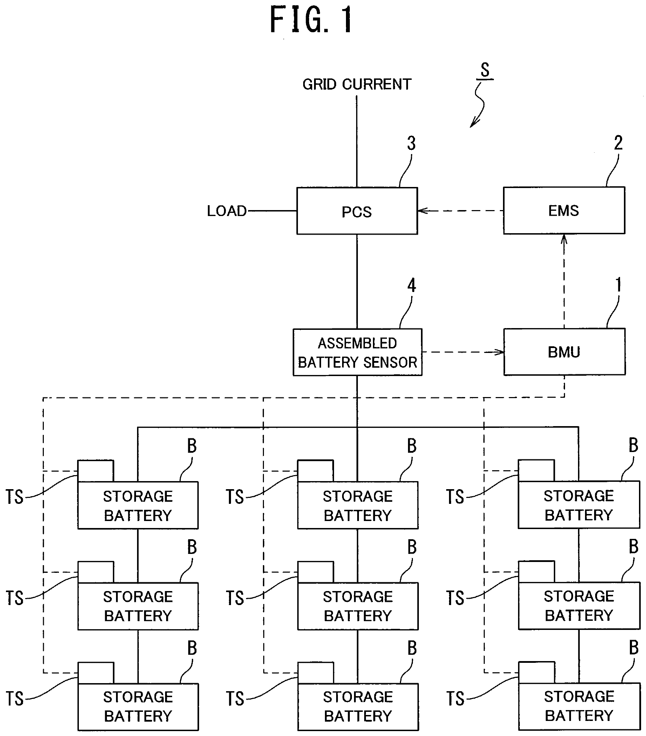

An overall configuration of a lead-acid battery system S according to an embodiment of the present invention will be described with reference to FIG. 1. FIG. 1 is a block diagram illustrating an overall configuration of the lead-acid battery system S according to the embodiment of the present invention.

The lead-acid battery system S is a system that stores, in the lead-acid battery B, a system current generated by various power plants such as thermal power plants or renewable energy such as wind power generation and transmitted. The lead-acid battery system S is a system that transmits power stored in the lead-acid battery B to a load such as a home, an office, or a factory as necessary. The lead-acid battery system S according to the embodiment of the present invention includes a BMU 1, an EMS 2, a PCS 3, and an assembled battery sensor 4 in addition to the lead-acid battery B.

The BMU 1 is a battery management unit, and is an apparatus that manages a voltage of each of cells constituting the lead-acid battery B, a temperature of the entire lead-acid battery B, and the like. Therefore, the BMU 1 is configured to enable the state of the lead-acid battery B to be ascertained via a sensor that acquires various types of information provided in the lead-acid battery B as will be described below. In addition, the BMU 1 according to the embodiment of the present invention includes, for example, a degradation estimation program necessary for estimating the degradation state in order to manage the degradation state of the lead-acid battery B.

Note that the function of the BMU 1 is not limited to the function described here. The BMU 1 may include other functions such as managing voltage balance in each cell, for example.

As the BMU 1, a personal computer (PC) or a microcomputer is used, for example. The BMU 1 may be installed in the vicinity of the lead-acid battery B, or may be configured to be managed on a cloud or to be managed remotely. A detailed configuration of the BMU 1 will be described below.

The EMS 2 is a so-called energy management system, and is a system through which a use state of power energy is ascertained, managed, and optimized. In addition, the PCS 3 is a power conditioning system, and serves a role of converting a direct current generated by the system current or the like into an alternating current and adjusting the alternating current to a stable output suitable for output to the load or storage in the lead-acid battery B.

The lead-acid battery B is a secondary battery using lead as an electrode. As the lead-acid battery B, a bipolar lead-acid battery is preferably applied, but any structure may be used. In addition, the number of installations, an installation method, and the like are not limited, and can be arbitrarily set. In the embodiment of the present invention, three lead-acid batteries (simply referred to as "storage batteries" in FIG. 1) B connected in series are connected in parallel.

As described above, in the lead-acid battery system S according to the embodiment of the present invention, the plurality of lead-acid batteries B are configured as an assembled battery, and the assembled battery sensor 4 for measuring a total voltage and a charge/discharge current of the assembled battery is connected. The information on the total voltage and the charge/discharge current measured by the assembled battery sensor 4 is transmitted to the BMU 1 and used as information for estimating the degradation degree of the lead-acid battery B in the BMU 1.

Furthermore, in the case of the lead-acid battery B according to the embodiment of the present invention, a temperature sensor TS for measuring the temperature of each lead-acid battery B is provided. As illustrated in FIG. 1, the temperature sensor TS is provided for each lead-acid battery B, and the temperature of the lead-acid battery B is also measured for each lead-acid battery B.

However, the temperature sensor TS may be provided not for each individual lead-acid battery B as described above, but for example, for each unit that is a set of lead-acid batteries. For the temperature of the lead-acid battery B to be measured, the temperature of a representative lead-acid battery B among the set of lead-acid batteries B may be measured, or the ambient temperature of the lead-acid battery B may be measured.

In the embodiment of the present invention, a direct current from a system current such as power generated in a power plant such as thermal power or from renewable energy is converted into an alternating current in the PCS 3, and output to a load and storage in the lead-acid battery B are performed.

In the BMU 1, as will be described below, switching of a charging/discharging process of the lead-acid battery B, the degradation degree, and the like are ascertained, and an operation command is issued to the EMS 2 in accordance with the state of the lead-acid battery B. This operation command is further transmitted to the PCS 3 to appropriately issue a command for charging or discharging with respect to the lead-acid battery B and perform the above-described output to the load and the like.

As illustrated in FIG. 1, in the embodiment of the present invention, five components of the lead-acid battery system S are the BMU 1, the EMS 2, the PCS 3, the assembled battery sensor 4, and the lead-acid battery B. However, the components of the lead-acid battery system S are not limited thereto.

In addition, it is also possible to impart the functions of the EMS 2 and the PCS 3 to the BMU 1, and in this case, the lead-acid battery system S includes the BMU 1, the assembled battery sensor 4, and the lead-acid battery B. Further, the assembled battery sensor 4 may not be independent, and a sensor for measuring current and voltage may be provided in each lead-acid battery B, for example.

In FIG. 1, the components are connected by a broken line arrow or a solid line. Here, a broken lone arrow indicates a flow of information, and information is transmitted in a direction of the arrow. On the other hand, a solid line indicates a flow of a current. Therefore, the power transmitted from the system current temporarily enters the PCS 3, the above-described processing is performed, and the power is stored in the lead-acid battery B via the assembled battery sensor 4. Then, the power stored in the lead-acid battery B is discharged and transmitted to a load.

Furthermore, as described above, the BMU 1 and the like may not be installed in the vicinity of the lead-acid battery B, and may be operable on a cloud or remotely. Therefore, information may be exchanged in the lead-acid battery system S either in a wired or wireless manner.

### [Internal Configuration of BMU]

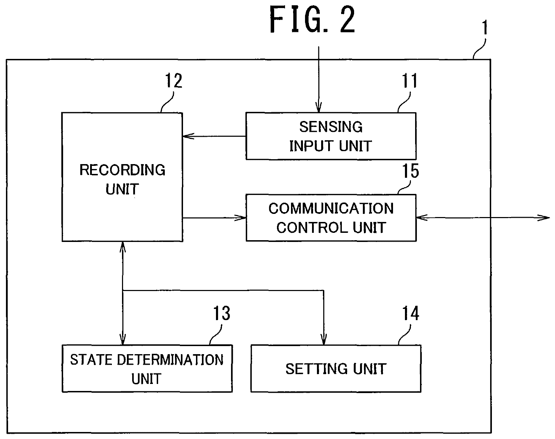

Next, the BMU 1 will be described in more detail. FIG. 2 is a block diagram illustrating an internal configuration of the BMU 1 according to the embodiment of the present invention. The BMU 1 includes a sensing input unit 11, a recording unit 12, a state determination unit 13A, a setting unit 14, and a communication control unit 15.

The sensing input unit 11 receives information related to a measurement value such as a current measured via the above-described various sensors provided in the assembled battery sensor 4 or the lead-acid battery B. In addition, the sensing input unit 11 may be set in such a manner that the information is continuously input or input during two times arbitrarily set in advance. The sensing input unit 11 may also be set in such a manner that the information is periodically input.

The recording unit 12 is configured from, for example, a semiconductor or a magnetic disk. The recording unit 12 records information regarding measurement values from various sensors received by the sensing input unit 11, information exchanged by the BMU 1 with the EMS 2, and the like.

The state determination unit 13A determines the state of the lead-acid battery B. The determination is performed as needed during normal operation as will be described below, for example. The determination is also performed when maintenance is performed on the lead-acid battery system S.

The setting unit 14 sets, for example, various thresholds to be described below, which are used when the degradation degree of the lead-acid battery B is determined in the state determination unit 13A. In setting the thresholds, an input unit and a display unit that are not illustrated in FIG. 2 are used.

The communication control unit 15 is a unit such as a LAN card or a modem, and is a unit that enables the BMU 1 to be connected to a communication network such as the Internet or a LAN wirelessly or by wire. In addition, by mediating connection with the EMS 2, the PCS 3, or the assembled battery sensor 4, information can be exchanged therebetween.

As described above, a PC or the like is used for the BMU 1. In FIG. 2, only the directly related functions in the embodiment of the present invention are illustrated, and the illustration of each unit normally included in the PC or the like is omitted. Therefore, each unit that is not illustrated will be described hereinafter.

The BMU 1 includes a configuration in which a central processing unit (CPU), a read only memory (ROM), a random access memory (RAM), and an input/output interface are connected via a bus. In addition, an input unit and a display unit used by a person who manages the lead-acid battery system S are connected to the input/output interface, and each unit illustrated in FIG. 2 described above is connected to the input/output interface.

The CPU reads out and executes a boot program for starting up the BMU 1 from the ROM based on an input signal from the input unit, and reads out various operating systems stored in the recording unit 12. The CPU may control the lead-acid battery B or the like based on an input signal from another external device that is not illustrated in FIG. 2 via the input unit or the input/output interface.

Further, the CPU reads programs and data stored in the RAM, the recording unit 12, or the like, and loads the programs and data into the RAM. The CPU is a processing device that realizes a series of processes such as management of the lead-acid battery B and calculation and processing of data necessary for estimating the degradation degree of the lead-acid battery B based on a command of a program read from the RAM.

The input unit includes, for example, an input device such as a keyboard or a touch panel to which a person who manages the lead-acid battery system S inputs various operations. When the administrator operates the input unit, an input signal is created and transmitted to the CPU via the bus.

The display unit is, for example, a liquid crystal display. The display unit receives an output signal from the CPU via the bus, and displays, for example, information on the degradation degree of the lead-acid battery B constituting the lead-acid battery system S or a processing result of the CPU.

In a case where the BMU 1 itself is operated by remote control, for example, the input unit and the display unit do not have to be provided inside the BMU 1. The BMU 1 may include functions other than those of the above-described units.

### [Internal Configuration of State Determination Unit]

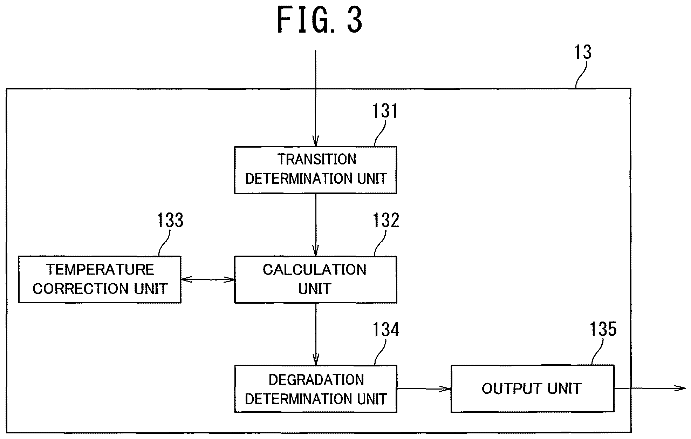

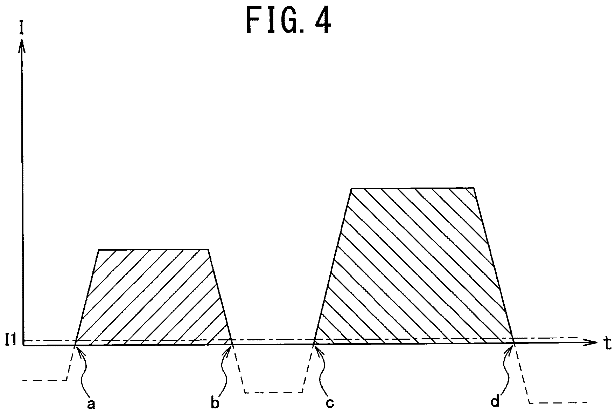

Next, the internal configuration of the state determination unit 13 will be described in more detail with reference to FIG. 4 as appropriate. FIG. 3 is a block diagram illustrating a detailed internal configuration of the state determination unit 13 according to the first embodiment of the present invention. FIG. 4 is an explanatory view illustrating a time course of charging/discharging process of the lead-acid battery B in the first embodiment of the present invention.

The state determination unit 13 includes a transition determination unit 131, a calculation unit 132, a temperature correction unit 133, a degradation determination unit 134, and an output unit 135. The output unit 135 transmits the result of the degradation determination of the lead-acid battery B determined by the state determination unit 13 to a display unit (not illustrated).

The transition determination unit 131 determines whether or not the lead-acid battery B has transitioned from the charging process to the discharging process. That is, in the embodiment of the present invention, the amount of discharge in the lead-acid battery B is used to determine the degradation degree of the lead-acid battery B. More specifically, the lead-acid battery B repeats the charging process and the discharging process, but the charge amount in the charging process is omitted and only the discharge amount is used.

That is, the transition determination unit 131 determines whether or not the lead-acid battery B has transitioned to the discharging process, and when it is determined that the lead-acid battery B has transitioned to the discharging process, the state determination unit 13 starts execution of the process of determining the degradation degree of the lead-acid battery B.

Here, in FIG. 4, a vertical axis represents a current value I, a horizontal axis represents time t, and a time course of the charging/discharging process in the lead-acid battery B is illustrated from left to right. In the case of the discharging process, the current value measured by the assembled battery sensor 4 shows a value of - (minus), and in the case of the charging process, the current value shows + (plus). Therefore, in FIG. 4, the current value illustrated upward from the horizontal axis is illustrated as a negative current value in consideration of visibility.

Therefore, in FIG. 4, the discharging process executed in the lead-acid battery B is indicated by a solid line on the upper side of the horizontal axis, and the charging process is indicated by a broken line on the lower side. From this, it can be seen that in the case of the charging/discharging process of the lead-acid battery B illustrated in FIG. 4, the charging process is initially performed, but then the first discharging process is performed, and then the second charging process, the second discharging process, the third charging process, and the charging/discharging process are repeatedly performed.

Here, the inside of each trapezoid indicating two times of discharging process is indicated by hatching, but the area of this trapezoid indicates a discharge capacity (discharge current value) integrated in a so-called one discharging process. Therefore, among the two discharging processes illustrated in FIG. 4, the integrated discharge capacity of the second discharging process is larger than that of the first discharging process.

A current value I1 indicated by an alternate long and short dash line is drawn in parallel with the horizontal axis immediately above the horizontal axis indicating the elapse of time. The current value I1 indicates a threshold for determining whether or not to terminate the processing for ascertaining the current amount. That is, it is assumed that the measurement result of the current value in the assembled battery sensor 4 does not indicate 0 even when there is no charge or discharge in terms of operation (the current value is 0). Therefore, as the current value I1, a small value such as substantially 0 is set in the setting unit 14. Hereinafter, the value set in this manner is referred to as a "threshold 11".

The transition determination unit 131 acquires information on the charge/discharge current value measured in the assembled battery sensor 4, and determines whether or not the current value is equal to or less than a preset threshold. When the transition determination unit 131 determines that the measured current value is equal to or less than the threshold, it can be ascertained that the charging/discharging process in the lead-acid battery B has transitioned from the charging process to the discharging process. In FIG. 4, for example, the positions are indicated by reference signs a and c.

That is, the "threshold" here is a value for determining whether or not the lead-acid battery B has transitioned from the charging process to the discharging process. The "threshold" is a value for determining whether the current value of the lead-acid battery B measured in the assembled battery sensor 4 has transitioned from plus to minus.

The transition determination unit 131 also determines whether the current value is smaller than the threshold 11. As described above, this is performed to determine whether or not to execute processing of continuously ascertaining the discharge current amount necessary for processing of determining the degradation degree of the lead-acid battery B after the lead-acid battery B transitions from the charging process to the discharging process.

On the other hand, the positions indicated by reference signs b and d are positions where the lead-acid battery B has transitioned from the discharging process to the charging process, and the transition determination unit 131 also determines the transition from the discharging process to the charging process. Specifically, this is a case where the current value measured in the assembled battery sensor 4 is not smaller than the threshold, that is, is larger than the threshold. When the lead-acid battery B transitions from the discharging process to the charging process as described above, the state determination unit 13 starts a process of determining the degradation degree of the lead-acid battery B using the measured current value or the like.

The calculation unit 132 of the state determination unit 13 calculates a value to be a determination criterion when the degradation determination unit 134 in the subsequent stage determines the degradation degree of the lead-acid battery B. The CT value is used as the determination criterion in the embodiment of the present invention. Here, the CT value is a value indicating capacitance turn-over, which is represented by a value obtained by dividing the total discharge capacity by the rated capacity of the lead-acid battery. The CT value is one of indices capable of indicating the state of the lead-acid battery B repeatedly used in the charging/discharging process.

That is, in the lead-acid battery B that repeats charging and discharging cycles, the number of times of discharging (the number of cycles) is determined under a certain condition. For example, when a certain lead-acid battery is described to be usable for 4500 cycles when used under the operation conditions of 25°C and a depth of discharge of 70%, the lead-acid battery can repeat the charging/discharging process 4500 times before the end of lifespan under this condition.

Therefore, if the total number of cycles up to the end of lifespan is known in advance and the number of cycles by use up to the present can be ascertained, the lifespan of the lead-acid battery B can be ascertained. Therefore, the approximate lifespan can be ascertained using a value obtained by dividing the number of charge/discharge cycles so far by the total number of cycles.

In addition, when the total discharge amount is known, if the discharge amount so far can be known, the approximate lifespan can be known even if a value obtained by dividing the discharge amount so far by the total discharge amount is used. The value ascertained in this manner is a so-called CT value, and in the embodiment of the present invention, this CT value is used when determining the degradation degree of the lead-acid battery B.

The calculation unit 132 calculates a CT value in one discharge period (a period indicated by one trapezoid in FIG. 4). As described above, in order to accurately ascertain the degradation degree of the lead-acid battery B, it is necessary to accurately ascertain the number of cycles or the amount of discharge in the lead-acid battery B used up to the present as much as possible. In order to ascertain the number of cycles or the amount of discharge, it is necessary to appropriately handle various conditions, particularly the depth of discharge.

Therefore, when the state determination unit 13 (calculation unit 132) calculates the CT value, first, as preparation for the calculation, information on the discharge current value and the temperature when the discharging process is executed is acquired. In the lead-acid battery system S according to the embodiment of the present invention, the discharge current value is measured by the assembled battery sensor 4, and the temperature is measured by the temperature sensor TS provided in each lead-acid battery B. Then, these pieces of information are transmitted to the BMU 1 and recorded in the recording unit 12 via the sensing input unit 11.

The discharge current values are sequentially integrated. This is to calculate the CT value in one discharging process as described above. Therefore, all the discharge current values in one discharging process are integrated.

For the integration of the discharge current value, for example, the discharge current value recorded in the recording unit 12 may be ascertained in the calculation unit 132 each time of measurement, and the discharge current value may be integrated in the calculation unit 132. Alternatively, the measured current value may be integrated and recorded in the recording unit 12.

Next, the calculation unit 132 calculates the depth of discharge based on the amount of discharge in the discharging process. This is so-called raw information reflecting the situation in which the lead-acid battery B has performed the discharging process. Then, based on the calculated depth of discharge, the calculation unit 132 further calculates a charge/discharge rate, a so-called C rate, from the magnitude of the current value when the value of the discharge current is measured in the assembled battery sensor 4. This is because the depth of discharge described above is affected by the value of the C rate.

Note that the C rate calculated here may be a value at a certain time point, or may be calculated as, for example, an average value on the basis of the C rate calculated each time the discharging process is executed.

In addition, the C rate may be calculated by the calculation unit 132 or may be ascertained by storing the relationship between the depth of discharge and the C rate in the recording unit 12 in advance and the calculation unit 132 retrieves the relationship between the depth of discharge and the C rate from the recording unit 12.

Then, the value of the depth of discharge is corrected using the calculated C rate. The calculation unit 132 corrects the value of the depth of discharge using the C rate, whereby an appropriate depth of discharge can be obtained in the discharge period in which the CT value is calculated.

Then, using the value of the depth of discharge corrected by the C rate, the calculation unit 132 calculates the CT value in the current discharge period. Here, since the CT value is the total discharge capacity or the number of cycles at the time when the CT value is calculated, the CT value is a value that is accumulated every time the CT value is calculated.

Therefore, by adding the CT value calculated according to the execution of the current discharging process to the CT value calculated based on the previous discharging process, the total CT value in the discharging process executed so far can be calculated. The processing of the calculation unit 132 described above is expressed as follows. CT value=previous CT value+integrated discharge capacity×Kdod (c)/reference discharge capacity

Here, "Kdod(c)" in Equation 1 indicates a value after the depth of discharge is corrected using the C rate. The reference discharge capacity is calculated by multiplying the rated capacity (Ah) by the depth of discharge (%) as a reference.

The discharge current value used to calculate the CT value needs to be corrected depending on the temperature. Therefore, the temperature correction unit 133 corrects the discharge current value so that the discharge current value is appropriately integrated.

That is, the temperature correction can be performed by the temperature correction unit 133 each time the discharge current value is measured and integrated. Equation 1 described above is an equation used when temperature correction is performed at the time of integration of discharge current values, and "integrated discharge capacity" is a value after temperature correction has already been executed.

Here, for example, with a predetermined temperature at which the degradation of the lead-acid battery B is accelerated as a boundary, the temperature correction unit 133 performs correction using a coefficient of a large value when the temperature is equal to or higher than the predetermined temperature and using "1" as the coefficient when the temperature is lower than the predetermined temperature.

On the other hand, the temperature correction unit 133 can also execute the temperature correction process on the discharge current value integrated at the time of executing the depth of discharge correction using the C rate. An equation used when the calculation unit 132 executes the CT value calculation process at that time is as follows. In the following Equation 2, "Kt" represents a temperature correction coefficient. CT value=previous CT value+integrated discharge capacity×Kt×Kdod (c)/reference discharge capacity

That is, the "integrated discharge capacity" in Equation 2 is not a value subjected to temperature correction by the temperature correction unit 133 when the discharge current value is measured and integrated, but is simply an integrated value. After all the discharge current values are integrated, the temperature correction process is collectively performed.

When the CT value calculation process is completed by the calculation unit 132, the value is transmitted to the degradation determination unit 134. The degradation determination unit 134 determines the degradation degree of the lead-acid battery B using the calculated CT value.

Specifically, for example, the determination can be performed by comparing the calculated CT value with a threshold set as a reference for determining the lifespan. This threshold is set in advance by the setting unit 14. The operator or the like of the lead-acid battery system S is notified of the determination result via the output unit 135.

As a mode of notifying the degradation degree which is a result of the determination, for example, various modes such as a mode represented by a numerical value on the display unit, a mode represented by a symbol such as "○" or "×", and a mode represented by a graph or the like can be adopted.

### [Operation]

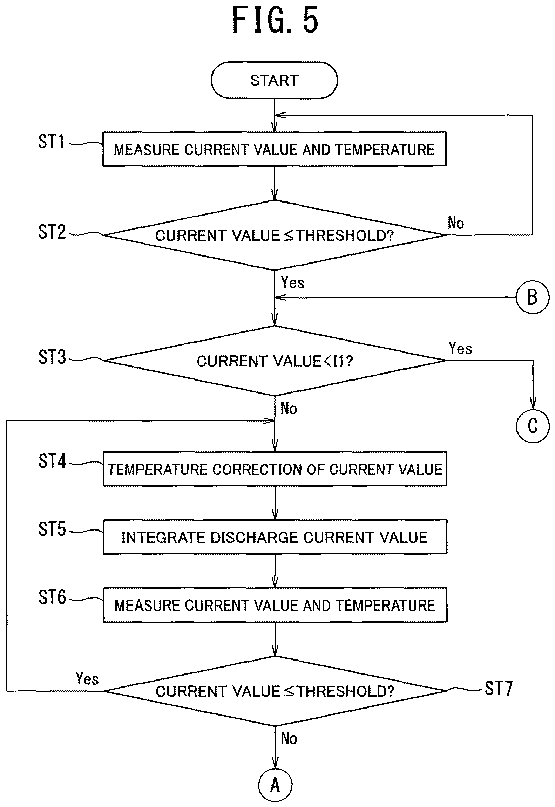

Next, a flow in which the BMU 1 determines the degradation degree of the lead-acid battery B will be first described with reference to FIGS. 5 to 7. FIGS. 5 to 7 are flowcharts illustrating the flow of determining the degradation degree of the lead-acid battery B using the lead-acid battery system S according to the first embodiment of the present invention, and the above-described Equation 1 is used.

First, the current value of the lead-acid battery B is measured by the assembled battery sensor 4, and the temperature of the lead-acid battery B is measured by the temperature sensor TS provided in the lead-acid battery B (ST1). Information regarding the current value and the temperature measured by each sensor is transmitted to the BMU 1 and recorded in the recording unit 12 via the sensing input unit 11.

Then, the transition determination unit 131 constituting the state determination unit 13 determines whether or not the lead-acid battery B has transitioned from the charging process to the discharging process, that is, whether or not the current value measured in the assembled battery sensor 4 is equal to or less than the threshold (ST2).

If the value of the current value is larger than the threshold (NO in ST2), it is determined that the charging process is continuously executed in the lead-acid battery B, and the process returns to step ST1 to continue the measurement of the current value and the temperature.

When it is determined that the current value measured by the transition determination unit 131 is equal to or less than the threshold (YES in ST2), it is determined that the lead-acid battery B has transitioned from the charging process to the discharging process. Further, in order to determine whether or not to continuously execute the process of ascertaining the current value, the transition determination unit 131 determines whether or not the discharge current value is a value smaller than the threshold I1 (ST3).

If it is determined by the transition determination unit 131 that the discharge current value is not smaller than the threshold I1 (NO in ST3), the discharging process is smoothly executed. Therefore, integration process of the discharge current value necessary for determining the degradation degree of the lead-acid battery B is started from here.

That is, first, the temperature correction unit 133 performs temperature correction on the discharge current value measured by the assembled battery sensor 4 (ST4). Then, the discharge current value subjected to the temperature correction process is integrated and recorded in the recording unit 12 (ST5). That is, every time the discharge current value is measured in the assembled battery sensor 4, temperature correction is performed, and the corrected discharge current value is integrated.

After the discharge current value and the temperature are measured again (ST6), the transition determination unit 131 determines again whether the discharge current value is equal to or less than the threshold (ST7). Here, the determination by the transition determination unit 131 is, for example, a determination as to whether or not the lead-acid battery B has transitioned from the discharging process to the charging process, which is indicated by a reference sign a to a reference sign b in FIG. 4.

If it is determined by the transition determination unit 131 that the discharging process is being continued (YES in ST7), the process continuously returns to step ST4. Then, temperature correction process and integration of the measured discharge current value, and measurement process of a new discharge current value and temperature are executed.

On the other hand, when the transition determination unit 131 determines that the measured current value is not equal to or less than the threshold (NO in ST7), it is determined that the lead-acid battery B has transitioned from the discharging process to the charging process. That is, this determination is made at the position of the reference sign b illustrated in FIG. 4.

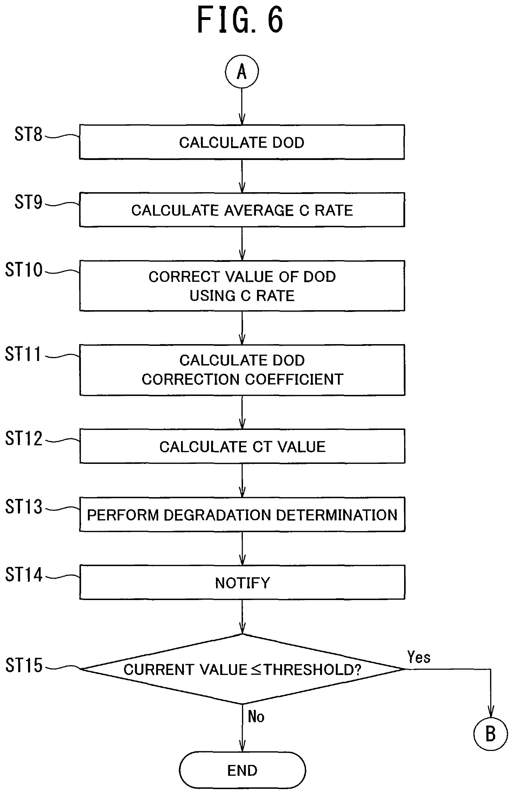

With this determination, one discharge period ends. Therefore, specifically, the CT value calculation process is started by the calculation unit 132. As described above, first, the depth of discharge is calculated (ST8 in FIG. 6). In FIG. 6, the depth of discharge is represented as "DOD".

The calculation unit 132 further calculates the average C rate (ST9), and corrects the value of the depth of discharge using the calculated average C rate (ST10). The value of the depth of discharge (the value of the corrected depth of discharge) to be used for the CT value calculation process is calculated by the correction (ST11). The calculation unit 132 calculates the CT value using the above-described Equation 1 (ST12).

The calculated CT value is transmitted from the calculation unit 132 to the degradation determination unit 134, and the degradation determination unit 134 performs the latest degradation determination on the lead-acid battery B (ST13). Then, the determination result is displayed on, for example, the display unit via the output unit 135 and notified to the operator of the lead-acid battery system S (ST14).

Here, the degradation determination process in the discharge period of the lead-acid battery B is completed. However, as illustrated in FIG. 4, in the lead-acid battery B, discharging process and charging process are alternately executed. Therefore, the transition determination unit 131 determines whether or not the current value measured by the assembled battery sensor 4 is equal to or less than a threshold (ST15).

As a result, if it is determined at this time point that the discharge period has started (YES in ST15), the process returns to step ST3 again, and the above-described degradation determination process for the lead-acid battery B is executed. On the other hand, in a case where the transition determination unit 131 determines that the current value is not equal to or less than the threshold, that is, the current value is a value larger than the threshold (NO in ST15), the charging process is still being executed. Therefore, the degradation determination process of the lead-acid battery B ends and the state shifts to the standby state.

After the transition determination unit 131 determines that the lead-acid battery B has transitioned from the charging process to the discharging process, it is determined whether the discharge current value corresponds to a value smaller than the threshold I1 as described above (ST2 and ST3 in FIG. 5). The case where it is determined that the discharge current value is larger than the threshold I1 (NO in ST3) has been described so far. On the other hand, when the discharge current value is smaller than the threshold I1, the following processing is executed.

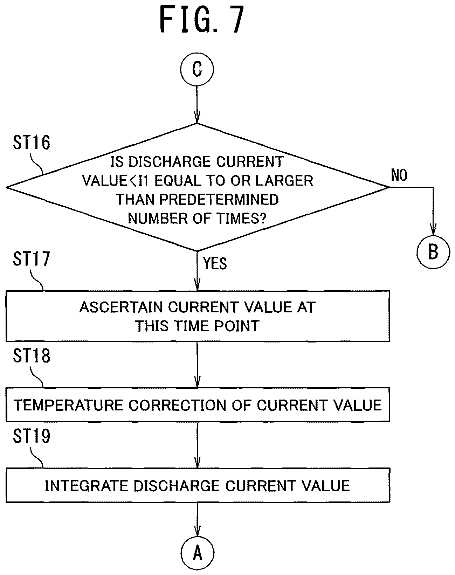

That is, when the transition determination unit 131 determines that the discharge current value is smaller than the threshold I1 (YES in ST3), the process proceeds to step ST16 in FIG. 7. Then, the transition determination unit 131 determines whether the discharge current value being smaller than the threshold I1 has been continuously measured a predetermined number of times or more.

The reason why such a determination is required is that even if the discharge current value shows a value smaller than the threshold I1 once, if it can be determined that the discharging process is continuously executed thereafter, the degradation determination process of the lead-acid battery B as described above can be executed. Note that the "predetermined number of times" used as the determination criterion here is a value set in advance in the setting unit 14, and can be arbitrarily set.

Therefore, when the transition determination unit 131 determines that the value at which the discharge current value is smaller than the threshold I1 is not equal to or larger than the predetermined number of times (NO in ST16), the process returns again to the determination process as to whether the discharge current value is smaller than the threshold I1 in step ST3.

On the other hand, when the transition determination unit 131 determines that the discharge current value is smaller than the threshold I1 the predetermined number of times or more (YES in ST16), it is determined that the discharging process is not to be continuously performed in the future. Therefore, the discharge current value at this time point is ascertained (ST17), and after temperature correction by the temperature correction unit 133 (ST18), integration process of the discharge current value is executed (ST19).

Then, the process proceeds to the CT value calculation process by the calculation unit 132 using the integrated discharge current value, and the above-described process is executed (ST8 and subsequent processes in FIG. 6).

As described above, in the lead-acid battery system S according to the embodiment of the present invention, the CT value is used in executing the degradation determination process of the lead-acid battery B. In the CT value calculation process, the discharge current amount during the discharging process of the lead-acid battery B is used.

By performing such processing, more accurate degradation determination process of the lead-acid battery using the CT value that is not affected by the cause of degradation of the lead-acid battery B can be executed. This leads to more accurate estimation of the degradation degree of the lead-acid battery, so that it is possible to provide a lead-acid battery system and a lead-acid battery life estimation method capable of contributing to further improvement of reliability.

Note that the flow of the CT value calculation process by the calculation unit 132 may be a flow described below in addition to the above-described flow. That is, the correction process based on the temperature of the discharge current value measured in the assembled battery sensor 4 can be executed not at the timing as described above but at another timing.

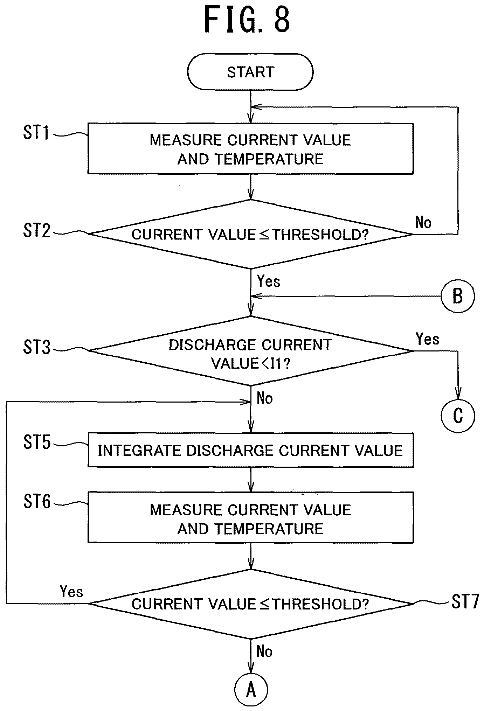

FIGS. 8 to 10 are flowcharts illustrating another flow of determining the degradation degree of the lead-acid battery B using the lead-acid battery system S according to the first embodiment of the present invention. In the CT value calculation process in the above description, for example, as illustrated in step ST4 of FIG. 5, the temperature correction of the measured discharge current value is executed every time the discharge current value is measured.

However, instead of the temperature correction process at this timing, the temperature correction process can be collectively executed on the integrated discharge current value using Equation 2 as described above. Therefore, for example, as illustrated in the flowchart of FIG. 8, after the transition determination unit 131 determines whether the discharge current value is smaller than the threshold I1, the temperature correction process is not performed, and the discharge current value integration process is immediately performed.

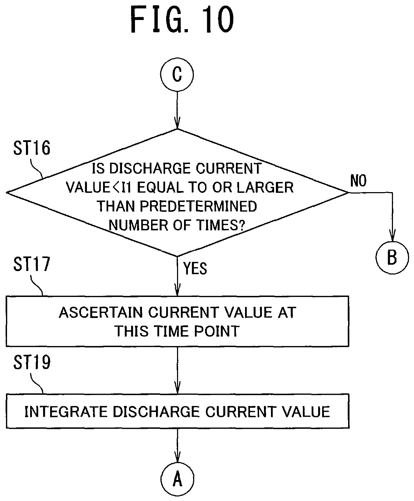

The same applies to a case where the transition determination unit 131 determines whether or not a state in which the discharge current value is smaller than the threshold I1 appears a predetermined number of times or more, and the discharge current value at this time point is ascertained as being equal to or larger than the predetermined number of times as illustrated in FIG. 10. The temperature correction process to the discharge current value ascertained here is not executed, and the process proceeds to the CT value calculation process.

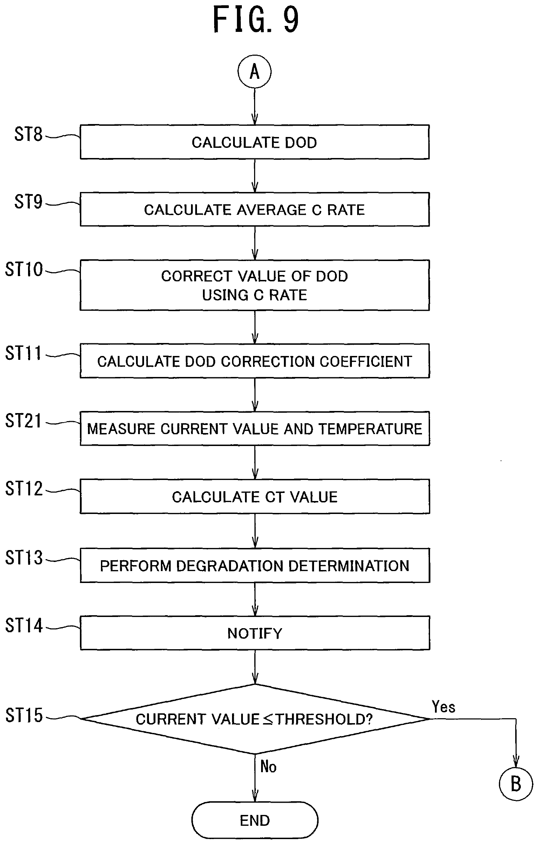

Here, the temperature correction process is executed by the temperature correction unit 133 after step ST8 (see FIG. 9) in which the value of the depth of discharge or the like is actually calculated by the calculation unit 132. Specifically, the processing is executed after the value of the depth of discharge is corrected by the C rate and the correction coefficient related to the depth of discharge is calculated and before the CT value is calculated (ST21, between ST11 and ST12). When the CT value is calculated by the calculation unit 132, the above-described Equation 2 is used.

As described above, the timing of the temperature correction process for the discharge current value can be performed immediately before the CT value is calculated. Therefore, more accurate degradation determination process of the lead-acid battery using the CT value that is not affected by the cause of degradation of the lead-acid battery B can be executed. This leads to more accurate estimation of the degradation degree of the lead-acid battery, so that it is possible to provide a lead-acid battery system and a lead-acid battery life estimation method capable of contributing to further improvement of reliability.

### (Second Embodiment)

Next, a second embodiment in the present invention is described. Note that, in the second embodiment, the same components as those described in the above-described first embodiment are denoted by the same reference signs, and the description of the same components will be omitted as appropriate because they overlap.

According to the lead-acid battery life estimation method in the second embodiment, degradation is not estimated by integrating a discharge current value with the discharge section described in the first embodiment as one section, but degradation is estimated by dividing the discharge section into a plurality of sections and integrating a discharge current value for each section.

### [Internal Configuration of State Determination Unit]

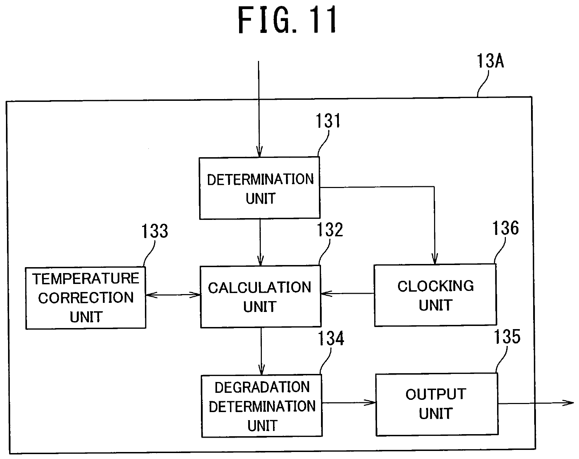

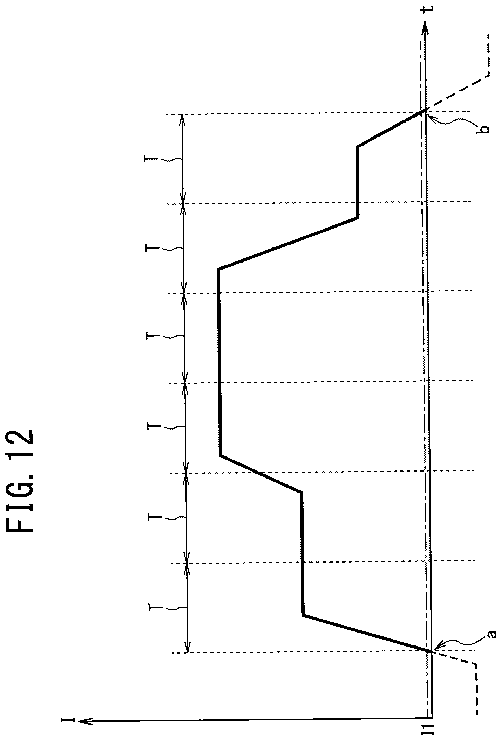

First, the internal configuration of the state determination unit 13A according to the second embodiment of the present invention will be described in more detail with reference to FIGS. 11 and 12 as appropriate. FIG. 11 is a block diagram illustrating a detailed internal configuration of a state determination unit 13A according to the second embodiment of the present invention. FIG. 12 is an explanatory view illustrating a time course of a charging/discharging process of the lead-acid battery B in the second embodiment of the present invention.

Here, in FIG. 12, the vertical axis represents the current value I, the horizontal axis represents the time t, and the time course of the charging/discharging process in the lead-acid battery B is illustrated from left to right. In addition, the drawing mode of FIG. 12 is similar to that of FIG. 4 in the first embodiment described above.

Therefore, in FIG. 12, the discharging process executed in the lead-acid battery B is indicated by a solid line on the upper side of the horizontal axis, and the charging process is indicated by a broken line on the lower side. From this, it can be seen that, in the case of the charging/discharging process of the lead-acid battery B illustrated in FIG. 12, the charging process was first performed, but thereafter, the discharging process was executed, and transition to the charging process was performed again. It is also illustrated that a discharge current value during a discharge period is not constant but changes.

Here, an area surrounded by the discharge current amount and the horizontal axis indicating the time t, which is indicated by transition from the charging process to the discharging process and transition from the discharging process to the charging process while changing the discharge current value, indicates the discharge capacity (discharge current value) integrated in the so-called discharging process.

Each unit constituting the state determination unit 13A is the same as that in the first embodiment, but the state determination unit 13A in the second embodiment that will be described below newly includes a clocking unit 136.

The transition determination unit 131 determines whether or not the lead-acid battery B has transitioned from the charging process to the discharging process. That is, also in the second embodiment of the present invention, the amount of discharge in the lead-acid battery B is used to determine the degradation degree of the lead-acid battery B. More specifically, the lead-acid battery B repeats the charging process and the discharging process, but the charge amount in the charging process is omitted and only the discharge amount is used.

The transition determination unit 131 determines whether or not the lead-acid battery B has transitioned to the discharging process, and when it is determined that the lead-acid battery B has transitioned to the discharging process, the state determination unit 13A starts execution of a process of determining the degradation degree of the lead-acid battery B.

Specifically, the transition determination unit 131 acquires information on the charge/discharge current value measured in the assembled battery sensor 4, and determines whether the current value is equal to or less than a preset threshold. When the transition determination unit 131 determines that the measured current value is equal to or less than the threshold, it can be ascertained that the charging/discharging process in the lead-acid battery B has transitioned from the charging process to the discharging process. In FIG. 12, for example, the position is indicated by a reference sign a.

That is, the "threshold" here is a value for determining whether or not the lead-acid battery B has transitioned from the charging process to the discharging process, and is a value for determining whether or not the current value of the lead-acid battery B measured in the assembled battery sensor 4 has transitioned from plus to minus.

The transition determination unit 131 also determines whether the current value is smaller than the threshold 11. As described above, this is performed to determine whether or not to execute processing of continuously ascertaining the discharge current amount necessary for processing of determining the degradation degree of the lead-acid battery B after the lead-acid battery B transitions from the charging process to the discharging process.

On the other hand, the position indicated by a reference sign b is a position where the lead-acid battery B has transitioned from the discharging process to the charging process, and the transition determination unit 131 also determines the transition from the discharging process to the charging process. Specifically, this is a case where the current value measured in the assembled battery sensor 4 is not smaller than the threshold, that is, is larger than the threshold. In this way, when the lead-acid battery B transitions from the charging process to the discharging process and further transitions from the discharging process to the charging process, the state determination unit 13A executes a process of determining the degradation degree of the lead-acid battery B using the measured current value or the like.

However, the degradation degree of the lead-acid battery B is not determined by integrating the discharge current value with the discharge period as one section. This is because the degradation degree can be determined more accurately by dividing the discharge period into a plurality of sections and using the discharge current value acquired in each section.

In addition, by dividing the discharge period into a plurality of sections in this manner, it is possible to reliably integrate the discharge current amount in a case where the change in the discharge current amount is small, and this also ultimately contributes to accurately determining the degradation degree.

Therefore, in the embodiment of the present invention, time is used as a method of dividing the discharge section into a plurality of sections. Therefore, the state determination unit 13A is provided with a clocking unit 136. The clocking unit 136 measures a set time set in advance in the setting unit 14. Here, in the embodiment of the present invention, as illustrated in FIG. 12, six set times T are set to divide the discharge period into six.

The set time T set by the setting unit 14 is 1 millisecond or more and 10 hours or less. Among these, the lower limit value "1 millisecond" is a device limit value that can be set by the state determination unit 13A. On the other hand, the upper limit value "10 hours" is the longest continuous charge/discharge time assumed in the lead-acid battery system S according to the second embodiment of the present invention.

The clocking unit 136 measures a preset set time T from when the transition determination unit 131 determines the transition of the state of the lead-acid battery B from the charging process to the discharging process to when the transition from the discharging process to the charging process is completed until the discharging process is completed. Then, the discharge current value is measured and integrated at every set time T measured by the clocking unit 136, and the temperature of the lead-acid battery B is measured.

In the clocking unit 136, measurement process for one set time T is performed from the start of the measurement to the arrival of the set time T among the plurality of set times T, and a clocking process of starting and ending the clocking of the repeatedly set time T is executed in the discharge period. Then, every time the set time T arrives, a signal indicating that the set time T has arrived is transmitted from the clocking unit 136 to the calculation unit 132.

Upon receiving the signal indicating that the set time T has arrived, the calculation unit 132 calculates a determination criterion necessary for determination of the degradation degree using the discharge current value integrated at the set time T as described below.

As the period in which the clocking unit 136 executes the clocking process, the measurement start time of the first set time after the transition determination unit 131 determines that the transition from the charging process to the discharging process is a time when the transition determination unit 131 determines that the lead-acid battery B has transitioned from the charging process to the discharging process. In addition, regarding the measurement end time of the set time, the time when the transition determination unit 131 determines that the lead-acid battery B has transitioned from the discharging process to the charging process can be defined as the measurement end time of the set time.

However, the measurement start time of the first set time after the transition determination unit 131 determines that the transition has been made from the charging process to the discharging process may be the time when the transition determination unit 131 performs the determination process as to whether the current value is smaller than the threshold I1 and determines that the current value is equal to or larger than the threshold I1 as described above.

Similarly, at the end of the measurement of the set time, the transition determination unit 131 may perform a determination process as to whether the current value is smaller than the threshold I1 and determine that the current value is less than the threshold I1.

As described above, the timing at which the transition determination unit 131 performs the determination process as to whether the current value is smaller than the threshold I1 is used as a trigger for the timing start and end of the set time by the clocking unit 136, so that the clocking process can be omitted when the current value is smaller than the threshold I1. This is because, in a case where the current value is smaller than the threshold I1 during the discharge period, the time is considered very short, and thus the effectiveness is considered small even if the clocking processing is performed in the clocking unit 136.

When the transition from the discharging process to the charging process of the lead-acid battery B is determined by the transition determination unit 131, the clocking process of the set time by the clocking unit 136 is ended, but the end time of the clocking process may not coincide with the expiration time of the set time being clocked. That is, this is a case where the transition determination unit 131 determines that the transition has been made from the discharging process to the charging process before the set time expires.

In such a case, the clocking unit 136 ends the measurement process of the set time at the time when the transition determination unit 131 determines the transition from the discharging process to the charging process. This is because the current value used for determining the degradation state of the lead-acid battery B in the embodiment of the present invention is only the discharge current value in the discharge period.

The calculation unit 132 of the state determination unit 13A calculates a value to be a determination criterion when the degradation determination unit 134 in the subsequent stage determines the degradation degree of the lead-acid battery B. The CT value is also used as the determination criterion in the embodiment of the present invention.

The calculation unit 132 calculates the CT value for each set time T obtained by dividing the discharge period by a plurality of set times T measured by the clocking unit 136. The sum of the CT values for each set time T is defined as the CT value in one discharge period. As described above, in order to accurately ascertain the degradation degree of the lead-acid battery B, it is necessary to accurately ascertain the number of cycles or the amount of discharge in the lead-acid battery B used up to the present as much as possible.

Therefore, in the embodiment of the present invention, the CT value in each set time is calculated by dividing one discharge period into a plurality of set times T, so that the CT value in the discharge period ascertained as the sum is calculated with higher accuracy.

Therefore, in a case where the state determination unit 13A (calculation unit 132) calculates the CT value, as preparation therefor, first, after the clocking unit 136 starts measuring the set time T, information regarding the discharge current value and the temperature when the discharging process is executed is acquired.

The clocking unit 136 executes a clocking process of determining whether or not the measured time has passed the set time T. The acquisition of the information on the discharge current value and the temperature is continued until end time of the set time T arrives. When the end time of the set time T arrives, the clocking unit 136 completes the measurement of the set time T. When the clocking process of the set time T by the clocking unit 136 is completed, next, the calculation unit 132 calculates the depth of discharge based on the amount of discharge in the discharging process.

This is so-called raw information reflecting the situation in which the lead-acid battery B has performed the discharging process. Then, based on the calculated depth of discharge, the calculation unit 132 further calculates a charge/discharge rate, a so-called C rate, from the magnitude of the current value when the value of the discharge current is measured in the assembled battery sensor 4.

Then, the value of the depth of discharge is corrected using the calculated C rate. The calculation unit 132 corrects the value of the depth of discharge using the C rate, whereby an appropriate depth of discharge can be obtained in the discharge period in which the CT value is calculated.

Using the value of the depth of discharge corrected by the C rate, the calculation unit 132 calculates the CT value at the current set time. Then, the CT value calculation process by the calculation unit 132 is executed for each set time T as long as the discharge period continues.

Next, when the transition determination unit 131 determines that the lead-acid battery B has transitioned from the discharging process to the charging process, the calculation unit 132 ends the calculation of the CT value for each set time T, and the calculation unit 132 adds all the plurality of CT values calculated for each set time T of the discharge period. The CT value obtained by adding is the total discharge capacity in the discharge period or the number of cycles.

Here, the CT value is a value that increases every time it is calculated. Therefore, by adding the CT value calculated according to the execution of the current discharging process to the CT value calculated based on the previous discharging process, the total CT value in the discharging process executed so far can be calculated. The processing of the calculation unit 132 here is expressed by Equation 1 described in the first embodiment.

On the other hand, the temperature correction unit 133 can also execute the temperature correction process on the discharge current value integrated at the time of executing the depth of discharge correction using the C rate. An equation used when the calculation unit 132 executes the CT value calculation process at that time is Equation 2.

When the CT value calculation process is completed by the calculation unit 132, the value is transmitted to the degradation determination unit 134. The degradation determination unit 134 determines the degradation degree of the lead-acid battery B using the calculated CT value.

Specifically, for example, the determination can be performed by comparing the calculated CT value with a threshold set as a reference for determining the lifespan. This threshold is set in advance by the setting unit 14. The operator or the like of the lead-acid battery system S is notified of the determination result via the output unit 135.

### [Operation]

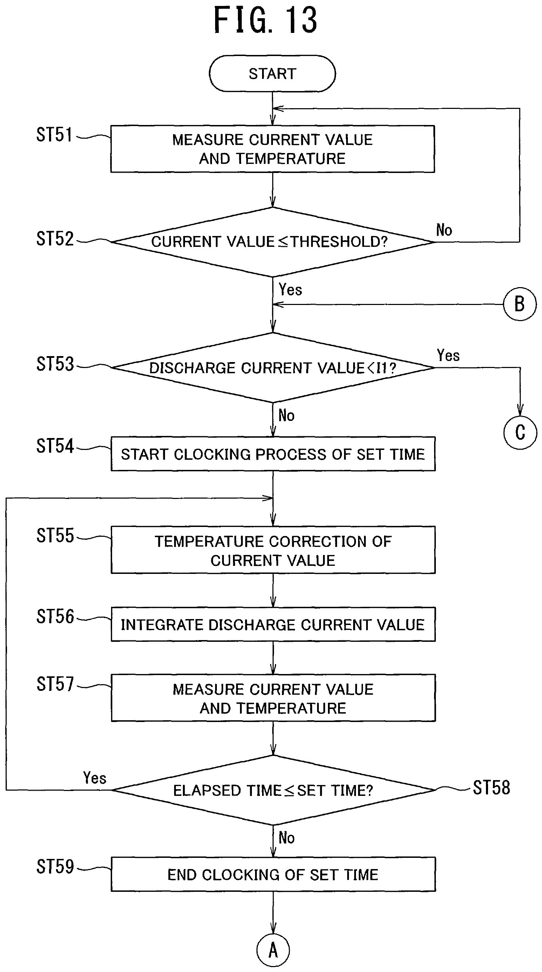

Next, a flow in which the BMU 1 determines the degradation degree of the lead-acid battery B will be first described with reference to FIGS. 13 to 15. FIGS. 13 to 15 are flowcharts illustrating the flow of determining the degradation degree of the lead-acid battery B using the lead-acid battery system S according to the second embodiment of the present invention, and the above-described Equation 1 is used.

First, the current value of the lead-acid battery B is measured by the assembled battery sensor 4, and the temperature of the lead-acid battery B is measured by the temperature sensor TS provided in the lead-acid battery B (ST51). Information regarding the current value and the temperature measured by each sensor is transmitted to the BMU 1 and recorded in the recording unit 12 via the sensing input unit 11.

Then, the transition determination unit 131 constituting the state determination unit 13A determines whether or not the lead-acid battery B has transitioned from the charging process to the discharging process, that is, whether or not the current value measured in the assembled battery sensor 4 is equal to or less than the threshold (ST52).

If the value of the current value is larger than the threshold (NO in ST52), it is determined that the charging process is continuously executed in the lead-acid battery B, and the process returns to step ST51 to continue the measurement of the current value and the temperature.

When it is determined that the current value measured by the transition determination unit 131 is equal to or less than the threshold (YES in ST52), it is determined that the lead-acid battery B has transitioned from the charging process to the discharging process. Further, in order to determine whether or not to continuously execute the process of ascertaining the current value, the transition determination unit 131 determines whether or not the discharge current value is a value smaller than the threshold I1 (ST53).

If it is determined by the transition determination unit 131 that the discharge current value is not smaller than the threshold I1 (NO in ST53), the discharging process is smoothly executed. Therefore, integration process of the discharge current value necessary for determining the degradation degree of the lead-acid battery B is started from here.

That is, first, the clocking unit 136 starts clocking process of the set time (ST54). In addition, the temperature correction unit 133 performs temperature correction on the discharge current value measured by the assembled battery sensor 4 (ST55). Then, the discharge current value subjected to the temperature correction process is integrated and recorded in the recording unit 12 (ST56). That is, every time the discharge current value is measured in the assembled battery sensor 4, temperature correction is performed, and the corrected discharge current value is integrated.

After the measurement of the discharge current value and the temperature measurement are performed again (ST57), it is determined whether the elapsed time measured by the clocking unit 136 indicates the arrival of the end time of the set time T (ST58).

In a case where the elapsed time does not exceed the set time T (YES in ST58), the processing returns to step ST55 described above, and the temperature correction process and the integration of the measured discharge current value, and the measurement process of a new discharge current value and temperature are executed.

On the other hand, as a result of measuring the elapsed time by the clocking unit 136, when the end time of the set time T has arrived (NO in ST58), it is determined that one set time T in the discharge period of the lead-acid battery B has expired. Therefore, the clocking unit 136 ends the clocking process of the set time T and transmits the fact that clocking process is ended to the calculation unit 132 (ST59).

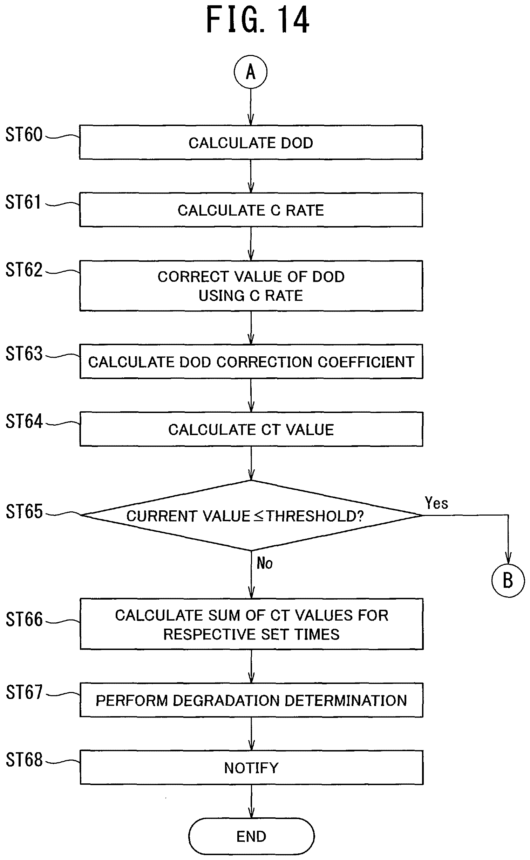

When the signal is transmitted from the clocking unit 136 to the calculation unit 132, the calculation unit 132 ascertains that one set time T has ended. Therefore, specifically, the CT value calculation process is started by the calculation unit 132. As described above, first, the depth of discharge is calculated (ST60 in FIG. 14). In FIG. 14, the depth of discharge is represented as "DOD".

The calculation unit 132 further calculates the average C rate (ST61), and corrects the value of the depth of discharge using the calculated average C rate (ST62). The value of the depth of discharge (the value of the corrected depth of discharge) to be used for the CT value calculation process is calculated by the correction (ST63). The calculation unit 132 calculates the CT value using the above-described Equation 1 (ST64).

Then, the transition determination unit 131 determines again whether the discharge current value is equal to or less than the threshold (ST65). Here, the determination by the transition determination unit 131 is determination of whether or not the lead-acid battery B has transitioned from the discharging process to the charging process.

If the transition determination unit 131 determines that the discharging process is being continued (YES in ST65), the process subsequently returns to step ST53. Since the measurement of one set time T in the discharge period has been completed, the clocking unit 136 continues to start the measurement of the next set time T, and the processes described so far, such as the temperature correction process and the integration of the discharge current value measured at the set time T, and the measurement process of a new discharge current value and temperature, are executed.

On the other hand, when the transition determination unit 131 determines that the process has transitioned to the charging process (NO in ST65), the calculation unit 132 adds the CT values for the respective set times T calculated so far for the respective set times T and calculates the sum thereof (ST66). The CT value as the sum is the CT value in the discharge period.

The calculated CT value is transmitted from the calculation unit 132 to the degradation determination unit 134, and the degradation determination unit 134 performs the latest degradation determination on the lead-acid battery B (ST67). Then, the determination result is displayed on, for example, the display unit via the output unit 135 and notified to the operator of the lead-acid battery system S (ST68). Here, the degradation determination process in the discharge period of the lead-acid battery B is completed.

However, as illustrated in FIG. 12, in the lead-acid battery B, when the discharging process ends, the process then transitions to the charging process. Here, while the discharging process is being continued during the transition from the discharging process to the charging process, there occurs a portion where it is necessary to determine whether or not the process for ascertaining the current amount may be continuously executed.

That is, when the discharging process is continued (YES in ST65), the transition determination unit 131 determines whether the discharge current value is smaller than the threshold I1 (ST53). As a result, when the discharge current value is smaller than the threshold II, the following processing is executed.

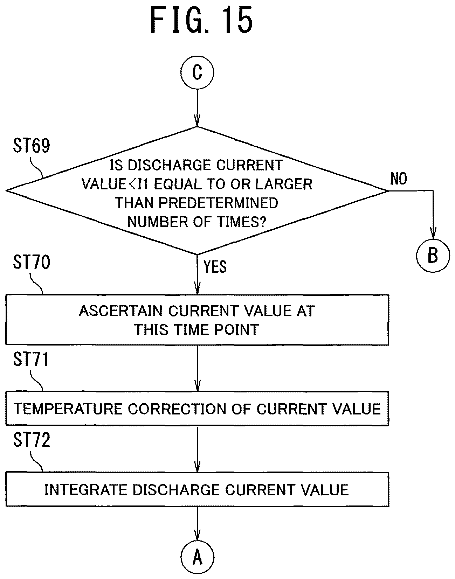

That is, when the transition determination unit 131 determines that the discharge current value is smaller than the threshold I1 (YES in ST53), the process proceeds to step ST69 in FIG. 15, and the transition determination unit 131 determines whether the discharge current value has been continuously measured to be smaller than the threshold I1 a predetermined number of times or more.

The reason why such a determination is required is that even if the discharge current value shows a value smaller than the threshold I1 once, if it can be determined that the discharging process is continuously executed thereafter, the degradation determination process of the lead-acid battery B as described above can be executed. Note that the "predetermined number of times" used as the determination criterion here is a value set in advance in the setting unit 14, and can be arbitrarily set.

Therefore, when the transition determination unit 131 determines that the value at which the discharge current value is smaller than the threshold I1 is not equal to or larger than the predetermined number of times (NO in ST69), the process returns again to the determination process of determining whether the discharge current value is smaller than the threshold I1 in step ST53.

On the other hand, when the transition determination unit 131 determines that the discharge current value is smaller than the threshold I1 the predetermined number of times or more (YES in ST69), it is determined that the discharging process is not to be continuously performed in the future. Therefore, the discharge current value at this time point is ascertained (ST70), and after temperature correction by the temperature correction unit 133 (ST71), integration process of the discharge current value is executed (ST72) .

Then, the process proceeds to the CT value calculation process by the calculation unit 132 using the integrated discharge current value, and the above-described process is executed (ST60 and subsequent stages in FIG. 14).

As described above, in the lead-acid battery system S according to the embodiment of the present invention, the CT value is used in executing the degradation determination process of the lead-acid battery B. In the CT value calculation process, the discharge current amount during the discharging process of the lead-acid battery B is used.

By performing such processing, more accurate degradation determination process of the lead-acid battery using the CT value that is not affected by the cause of degradation of the lead-acid battery B can be executed. This leads to more accurate estimation of the degradation degree of the lead-acid battery, so that it is possible to provide a lead-acid battery system and a lead-acid battery life estimation method capable of contributing to further improvement of reliability.

In particular, by executing the processing of measuring and integrating the discharge current amount in the discharge period for each section obtained by dividing the discharge period by a plurality of set times, it is possible to more accurately integrate the discharge current value. Then, after the CT for each set time is calculated using the information obtained by these processes, the sum of the CT values in the discharge period is calculated, and the degradation degree of the lead-acid battery is estimated using the sum of the CT values. By executing such process, it is possible to finally estimate the degradation degree with higher accuracy.

Note that the flow of the CT value calculation process by the calculation unit 132 may be a flow described below in addition to the above-described flow. That is, the correction process based on the temperature of the discharge current value measured in the assembled battery sensor 4 can be executed not at the timing as described above but at another timing.

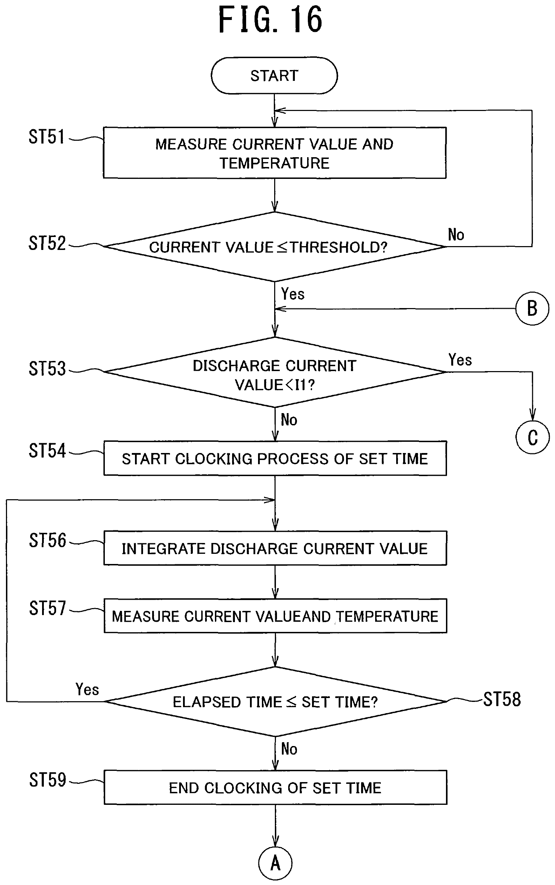

FIGS. 16 to 18 are flowcharts illustrating another flow of determining the degradation degree of the lead-acid battery B using the lead-acid battery system S according to the second embodiment of the present invention. In the CT value calculation process in the above description, for example, as illustrated in step ST55 of FIG. 13, the temperature correction of the measured discharge current value is executed every time the discharge current value is measured.

However, instead of the temperature correction process at this timing, the temperature correction process can be collectively executed on the integrated discharge current value using Equation 2 as described above. Therefore, for example, as illustrated in the flowchart of FIG. 16, after the transition determination unit 131 determines whether or not the discharge current value is smaller than the threshold I1, and after the measurement process of the set time in the clocking unit 136 is started, the temperature correction process is not performed, and the discharge current value integration process is performed immediately.

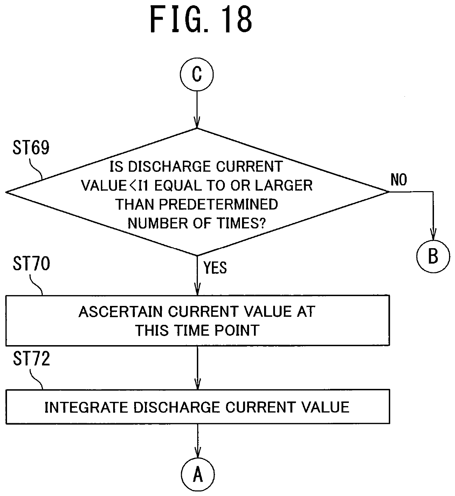

The same applies to a case where the transition determination unit 131 determines whether or not a state in which the discharge current value is smaller than the threshold I1 appears a predetermined number of times or more, and the discharge current value at this time point is ascertained as being equal to or larger than the predetermined number of times as illustrated in FIG. 18. The temperature correction process to the discharge current value ascertained here is not executed, and the process proceeds to the CT value calculation process.

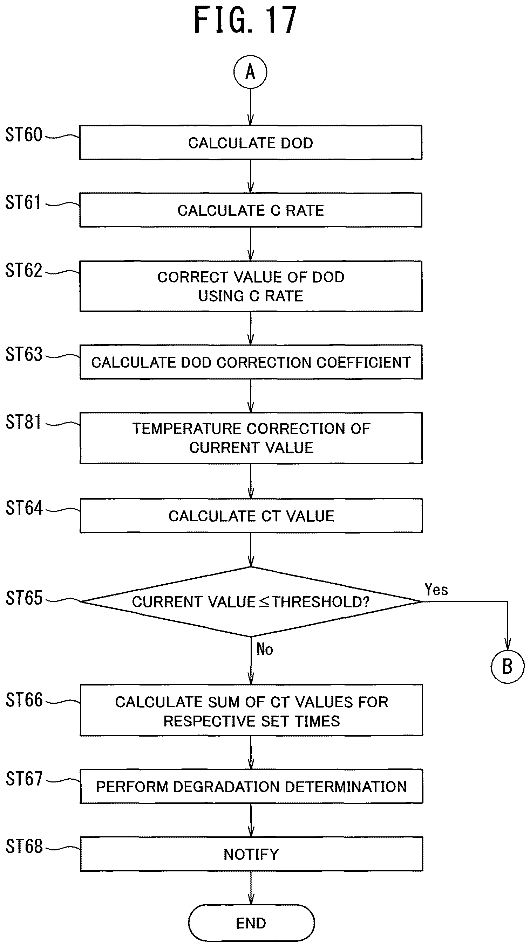

Here, the temperature correction process is executed by the temperature correction unit 133 after step ST60 (see FIG. 17) in which the value such as the depth of discharge is actually calculated by the calculation unit 132. Specifically, the processing is executed after the value of the depth of discharge is corrected by the C rate and the correction coefficient related to the depth of discharge is calculated and before the CT value is calculated (ST81, between ST63 and ST64). When the CT value is calculated by the calculation unit 132, the above-described Equation 2 is used.

As described above, the timing of the temperature correction process for the discharge current value can be performed immediately before the CT value is calculated. Therefore, more accurate degradation determination process of the lead-acid battery using the CT value that is not affected by the cause of degradation of the lead-acid battery B can be executed. This leads to more accurate estimation of the degradation degree of the lead-acid battery, so that it is possible to provide a lead-acid battery system and a lead-acid battery life estimation method capable of contributing to further improvement of reliability.

Since the process of measuring and integrating the discharge current amount in the discharge period is not changed to be executed for each section obtained by dividing the discharge period by a plurality of set times, the discharge current value can be integrated more accurately, and the degradation degree of the lead-acid battery can finally be estimated with higher accuracy.

In the above description, as illustrated in FIG. 12, the set time T is set such that all of the plurality of set times T are the same time. However, it is not necessary to set the set time T so as to equally divide the time in the discharge period, and for example, a plurality of set times may be set to be different from each other.

The technology described in the embodiment of the present invention can adopt the following configuration.
(1) A lead-acid battery system including:
   a transition determination unit configured to determine switching of charging/discharging process of a lead-acid battery; a calculation unit configured to calculate a CT value based on a discharge current value during a discharge period of the lead-acid battery; and a degradation determination unit configured to determine a degradation degree of the lead-acid battery using the CT value calculated by the calculation unit.
(2) The lead-acid battery system according to (1), wherein the calculation unit starts a calculation process of the CT value when the transition determination unit determines that the discharge period ends after the lead-acid battery transitions from the discharge period to a charge period.
(3) The lead-acid battery system according to (2), wherein the calculation unit executes the calculation process of the CT value using the discharge current value after temperature correction on a basis of a result of a temperature correction process to the measured discharge current value executed after transition to the charge period.
(4) The lead-acid battery system according to (1), further including: a clocking unit configured to measure a plurality of set times set in advance in a discharge period in which the lead-acid battery performs a discharging process,
   wherein the calculation unit calculates a CT value based on a discharge current value in the set time.
(5) The lead-acid battery system according to (4), wherein the clocking unit repeatedly measures a plurality of the set times set in the discharge period for each set time.
(6) The lead-acid battery system according to claim 4 or (5), wherein the clocking unit ends the measurement of the set time when the transition determination unit determines that the lead-acid battery has transitioned from the discharge period to a charge period.
(7) The lead-acid battery system according to any one of (4) to (6), wherein the set time is 1 millisecond or more and 10 hours or less.
(8) The lead-acid battery system according to any one of (4) to (7), wherein the calculation unit calculates a CT value for each of the plurality of set times, and calculates a sum of the calculated CT values as the CT value in the discharge period.
(9) The lead-acid battery system according to any one of (4) to (8), wherein the calculation unit starts the calculation process of the CT value when the clocking unit determines that the set time has elapsed.
(10) The lead-acid battery system according to any one of (1) to (9), wherein the calculation unit executes the calculation process of the CT value using the discharge current value after temperature correction on the basis of a result of a temperature correction process to the measured discharge current value executed after the measurement of the set time is started by the clocking unit.
(11) The lead-acid battery system according to any one of (1) to (9), wherein the calculation unit executes a temperature correction process to the discharge current value after the calculation process of the CT value is started and before the CT value is calculated.
(12) A lead-acid battery life estimation method, including:
   determining whether or not a lead-acid battery is switched from a charging process to a discharging process;
   measuring a current in the discharging process when it is determined that the lead-acid battery is switched to the discharging process;
   integrating measured discharge current values;
   determining whether the lead-acid battery is switched from the discharging process to the charging process; and
   executing a calculation process of a CT value using the integrated discharge current value when it is determined that the lead-acid battery is switched from the discharging process to the charging process.
(13) A lead-acid battery life estimation method, including:
   determining whether or not a lead-acid battery is switched from a charging process to a discharging process;
   starting measurement of a preset set time;
   measuring a current in the discharging process after the measurement of the set time is started;
   integrating measured discharge current values;
   determining whether the set time has elapsed;
   executing a calculation process of a CT value using the integrated discharge current value when it is determined that the set time has elapsed; and
   calculating a sum of the CT values calculated for each set time.
(14) The lead-acid battery life estimation method according to (13), wherein the set time is 1 millisecond or more and 10 hours or less.
(15) The lead-acid battery life estimation method according to any one of (12) to (14), further including performing temperature correction to the measured discharge current value after the step of measuring the discharge current.
(16) The lead-acid battery life estimation method according to any one of (12) to (14), wherein in the calculating the CT value, a temperature correction process to the integrated discharge current value is executed.
(17) The lead-acid battery life estimation method according to any one of (12), (15), and (16), further including determining a degradation degree of the lead-acid battery using the calculated CT value after the calculation process of the CT value.
(18) The lead-acid battery life estimation method according to any one of (13) to (16), further including determining a degradation degree of the lead-acid battery using the calculated CT value after the calculation process of the sum of the CT values.

### Reference Signs List

- 1: BMU
- 2: EMS
- 3: PCS
- 4: Assembled battery sensor
- 11: Sensing input unit
- 12: Recording unit
- 13, 13A: State determination unit
- 131: Determination unit
- 132: Calculation unit
- 133: Temperature correction unit
- 134: Degradation determination unit
- 135: Output unit
- 136: Clocking unit
- 14: Setting unit
- 15: Communication control unit
- S: Lead-acid battery system

## Claims

1. A lead-acid battery system comprising:
a transition determination unit configured to determine switching of charging/discharging process of a lead-acid battery;
a calculation unit configured to calculate a CT value based on a discharge current value during a discharge period of the lead-acid battery; and
a degradation determination unit configured to determine a degradation degree of the lead-acid battery using the CT value calculated by the calculation unit.

2. The lead-acid battery system according to claim 1, wherein the calculation unit starts a calculation process of the CT value when the transition determination unit determines that the discharge period ends after the lead-acid battery transitions from the discharge period to a charge period.

3. The lead-acid battery system according to claim 2, wherein the calculation unit executes the calculation process of the CT value using the discharge current value after temperature correction on a basis of a result of a temperature correction process to the measured discharge current value executed after transition to the charge period.

4. The lead-acid battery system according to claim 1, further comprising:
a clocking unit configured to measure a plurality of set times set in advance in a discharge period in which the lead-acid battery performs a discharging process,
wherein the calculation unit calculates a CT value based on a discharge current value in the set time.

5. The lead-acid battery system according to claim 4, wherein the clocking unit repeatedly measures a plurality of the set times set in the discharge period for each set time.

6. The lead-acid battery system according to claim 4, wherein the clocking unit ends the measurement of the set time when the transition determination unit determines that the lead-acid battery has transitioned from the discharge period to a charge period.

7. The lead-acid battery system according to claim 4, wherein the set time is 1 millisecond or more and 10 hours or less.

8. The lead-acid battery system according to claim 4, wherein the calculation unit calculates a CT value for each of the plurality of set times, and calculates a sum of the calculated CT values as the CT value in the discharge period.

9. The lead-acid battery system according to claim 4, wherein the calculation unit starts the calculation process of the CT value when the clocking unit determines that the set time has elapsed.

10. The lead-acid battery system according to any one of claims 1 to 9, wherein the calculation unit executes the calculation process of the CT value using the discharge current value after temperature correction on the basis of a result of a temperature correction process to the measured discharge current value executed after the measurement of the set time is started by the clocking unit.

11. The lead-acid battery system according to any one of claims 1 to 9, wherein the calculation unit executes a temperature correction process to the discharge current value after the calculation process of the CT value is started and before the CT value is calculated.

12. A lead-acid battery life estimation method, comprising:
determining whether or not a lead-acid battery is switched from a charging process to a discharging process;
measuring a current in the discharging process when it is determined that the lead-acid battery is switched to the discharging process;
integrating measured discharge current values;
determining whether the lead-acid battery is switched from the discharging process to the charging process; and
executing a calculation process of a CT value using the integrated discharge current value when it is determined that the lead-acid battery is switched from the discharging process to the charging process.

13. A lead-acid battery life estimation method, comprising:
determining whether or not a lead-acid battery is switched from a charging process to a discharging process;
starting measurement of a preset set time;
measuring a current in the discharging process after the measurement of the set time is started;
integrating measured discharge current values;
determining whether the set time has elapsed;
executing a calculation process of a CT value using the integrated discharge current value when it is determined that the set time has elapsed; and
calculating a sum of the CT values calculated for each set time.

14. The lead-acid battery life estimation method according to claim 13, wherein the set time is 1 millisecond or more and 10 hours or less.

15. The lead-acid battery life estimation method according to any one of claims 12 to 14, further comprising performing temperature correction to the measured discharge current value after the step of measuring the discharge current.

16. The lead-acid battery life estimation method according to any one of claims 12 to 14, wherein in the calculating the CT value, a temperature correction process to the integrated discharge current value is executed.

17. The lead-acid battery life estimation method according to claim 12, further comprising determining a degradation degree of the lead-acid battery using the calculated CT value after the calculation process of the CT value.

18. The lead-acid battery life estimation method according to claim 13, further comprising determining a degradation degree of the lead-acid battery using the calculated CT value after the calculation process of the sum of the CT values.
